# EUROPEAN PATENT SPECIFICATION

(11) **EP 1 520 208 B1**
(45) Date of publication and mention of the grant of the patent: **28.02.2007**
(21) Application number: 03740910.9
(22) Date of filing: 13.06.2003
(51) Int. Cl.: G03F 1/14, G03F 1/08

(54) **MASK AND MANUFACTURING METHOD USING MASK**
MASKE UND EIN DIESE MASKE BENUTZENDES HERSTELLUNGSVERFAHREN
MASQUE ET PROCEDE DE FABRICATION L'UTILISANT

(30) Priority: 02.07.2002 GB 0215243
(43) Date of publication of application: 06.04.2005
(73) Proprietor: Koninklijke Philips Electronics N.V., 5621 BA Eindhoven (NL)
(72) Inventor: FRENCH, Ian D., Philips Intellectual Prop. & Std., Redhill, Surrey RH1 5HA (GB); HEWETT, James, Philips Intellectual Prop. & Std., Redhill, Surrey RH1 5HA (GB)
(74) Representative: Damen, Daniel Martijn
(86) International application number: PCT/IB2003/002939
(87) International publication number: WO 2004/006016

(56) References cited:
- US-A- 4 863 755
- US-A- 5 015 353
- US-A- 5 733 686
- US-A- 5 907 393
- US-A- 6 045 954
- US-A1- 2002 053 748
- US-A1- 2002 076 622
- US-B1- 6 391 499
- PATENT ABSTRACTS OF JAPAN vol. 012, no. 224 (P-721), 25 June 1988 (1988-06-25) & JP 63 018351 A (HITACHI MICRO COMPUT ENG LTD;OTHERS: 01), 26 January 1988 (1988-01-26)

## Description

The invention relates to a method of manufacture suitable for use in the manufacture of thin film device arrays, particularly but not exclusively for use in the production of active matrix liquid crystal displays (AMLCDs) as well as micro-electrical-mechanical systems (MEMS). The invention also relates to a mask used in such a method, the use of the mask and a method of manufacture of the mask.

The reduction of the number of process steps and the simplification of process steps is an important means of reducing the manufacturing cost for devices such as AMLCDs and x-ray image sensors. One approach for reducing the number of steps is to use a single photolithography step to define two levels of photoresist. The photo-mask used in such a process may have three regions. One region is completely clear to allow ultraviolet (UV) to pass through, a second region is solid to prevent UV light passing through, and a third region includes a plurality of slits acting as a diffraction mask allowing a reduced transmission of UV through the third region of the mask. Because these slits spread the UV light passing through the mask by diffraction, a relatively uniform light intensity may be obtained beneath the slits.

There are three main problems associated with the use of diffraction masks. Firstly, mask cost is a function of the minimum feature size. Smaller feature sizes need more time to write the mask and are therefore more expensive. Diffraction masks need much smaller feature sizes than normal masks, for example gaps and lines of the order of 0.4µm to 1.5µm instead of 5µm for normal photolithography of AMLCDs. This makes the masks expensive and difficult to manufacture. Only a very small number of mask manufacturers have the capability of making such small feature sizes on the large masks used for manufacturing AMLCDs.

Secondly, the uniformity of mask writing is poor for small feature sizes. Since the amount of light reaching the substrate in the diffraction grating area is a strong function of the slit size, a process using such diffraction masks is prone to poor uniformity of photoresist thickness in the areas exposed by the diffraction grid.

Thirdly, the diffraction effect inevitably means that the light intensity profile has sloped edges. The sloped edge of the light intensity profile translates into a sloped edge profile of photoresist. To define the second photoresist pattern the photoresist must be partially etched in an oxygen plasma. The oxygen plasma etch, photoresist spinning and UV exposure are not perfectly uniform for large substrates and this will cause different thicknesses of photoresist to be etched at different positions on the substrate, and this in turn leads to inaccuracies in feature size.

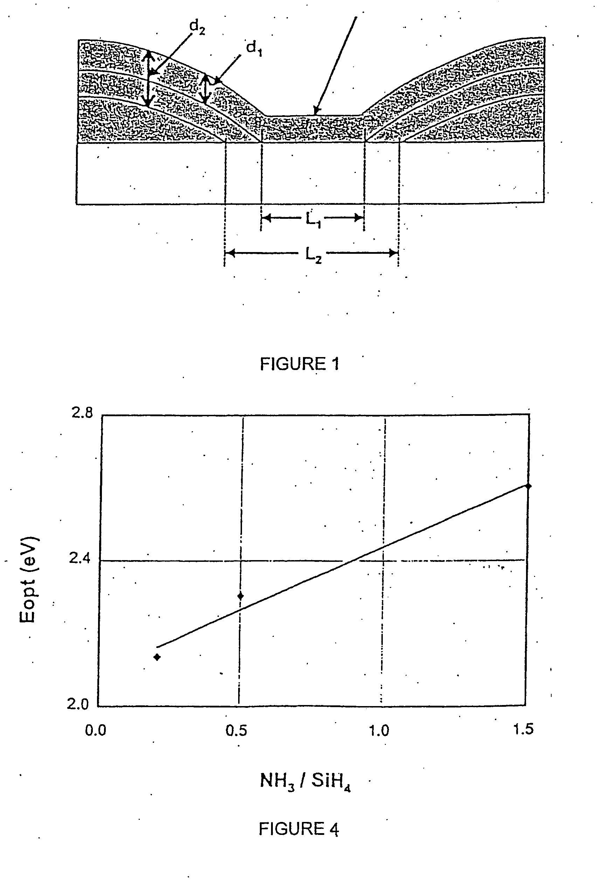

Figure 1 illustrates the effect of this. If the photoresist is partially etched by thickness d₁ the size of the gap is L₁, but if the etched thickness is d₂ then the gap length will be L₂. Thus, small variations in thickness can cause significant variations in feature size. This variation is a problem in applications for which feature size control is important, for example when defining the thin film transistor (TFT) channel length of AMLCDs.

Thus, there remains a need for a process for manufacturing AMLCDs and other devices that addresses these inconveniences.

US-6,391,499 describes a light exposure mask comprising a light transmitting region, a light shielding region and a light semi-transmitting region. A layer of photoresist is developed by exposure to UV light through the mask. The developed photoresist pattern has a thick portion corresponding to the light shielding region and a relatively thin portion corresponding to the light semi-transmitting region.

According to the invention, there is provided a half-tone mask, as defined by Claim 1.

The mask according to the invention uses silicon-rich silicon nitride. The inventors have realised that this material has a property that makes it very useful in the specific application. Specifically, the fraction x of nitrogen in the mask layer can be varied easily by manufacturing the mask layer using plasma deposition and varying the amounts of ammonia (NH₃) and silane (SiH₄), and so it is possible to vary the optical band gap of the silicon nitride. Tests carried out by the inventors have shown that the optical band gap of mask silicon nitride is a much more important parameter for determining the optical transmission of a layer of silicon nitride than small variations in the thickness of that layer. Thus, it is possible to accurately control the transmission of ultraviolet light through the half-tone layer of silicon-rich silicon nitride by accurately controlling the fraction of nitrogen in the layer.

Further, it is possible to make masks suitable for a variety of different ultraviolet wavelengths. By varying the fraction of nitrogen it is possible to produce half-tone mask material layers suitable for use with UV light sources having a variety of ultraviolet wavelengths, including the i-line at 365nm, the h-line at 405nm and the g-line at 436nm.

Preferably, the silicon-rich silicon nitride layer has a value of x in the range 0.2 to 0.6 and an optical band gap of from 2.1eV to 2.5eV, preferably less than 2.35eV. The silicon-rich silicon nitride layer preferably has a thickness of from 40nm to 1 00nm.

The invention also relates to the use of the mask described above to pattern a layer of photoresist by passing ultraviolet light through the mask onto the layer of photoresist to define fully removed regions in which the photoresist is fully removed, thick regions having a first thickness and thin regions having a thickness less than the first thickness in the regions exposed through the half-tone regions.

The invention also relates to a method of manufacture of a half-tone mask as defined by Claim 5.

In another aspect, the invention relates to a method of manufacture of a thin film device according to Claim 6.

For a better understanding of the invention, embodiments will now be described, purely by way of example, with reference to the accompanying drawings in which:
Figure 1 illustrates the variation in feature length due to different plasma etched depths;
Figures 2(a) to 2(e) illustrate stages in the manufacture of a display in a method according to the invention;
Figure 3 shows a top view of a TFT manufactured in accordance with the invention;
Figure 4 shows the optical band gap as a function of nitrogen to silane ratio;
Figure 5 shows the transmission as a function of wavelengths and optical band gap; and
Figure 6 shows the optical transmission through different thicknesses of silicon nitride.

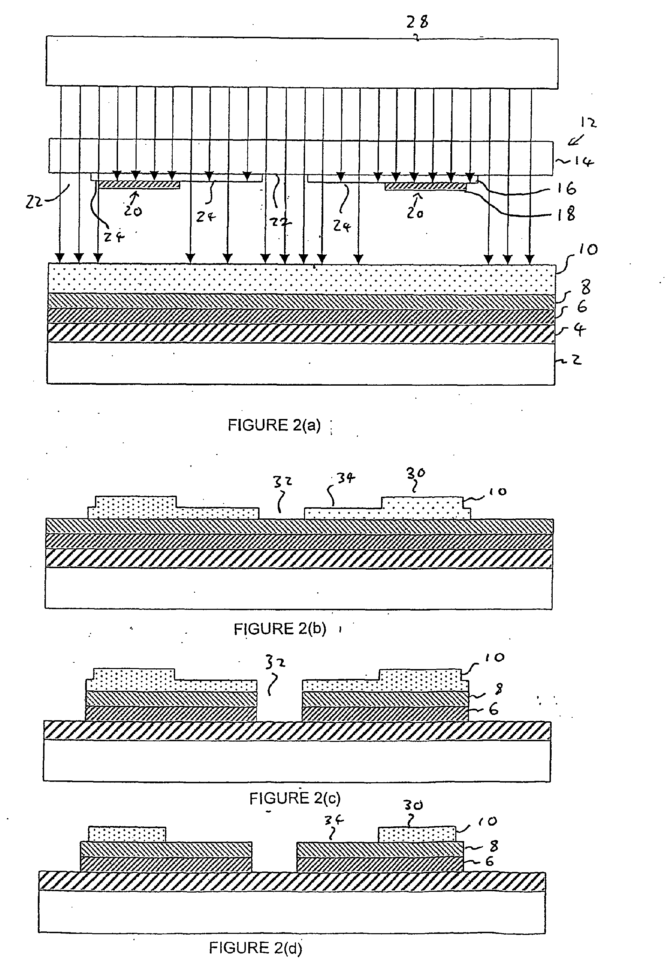

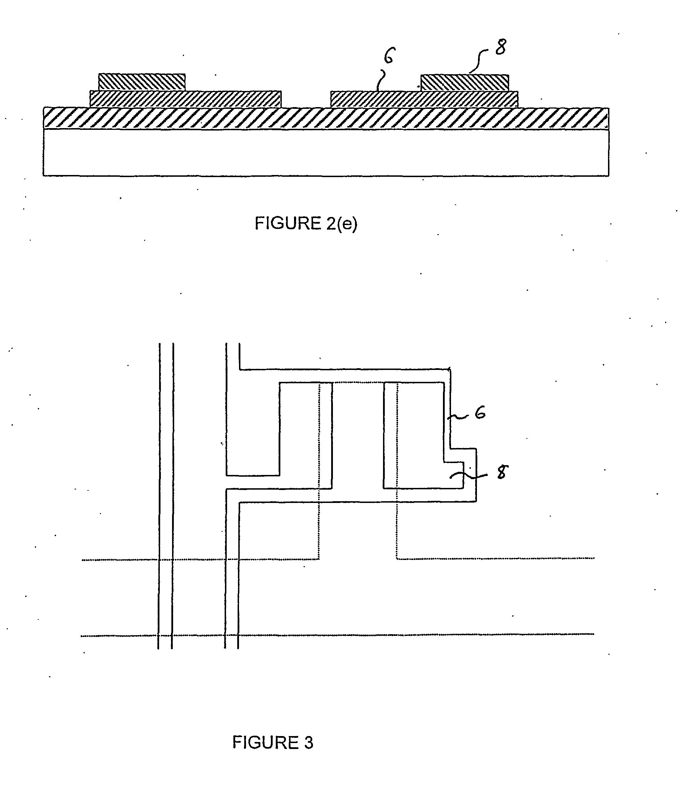

Referring to Figure 2, a method of making TFT arrays will now be described. Referring to Figure 2a, a substrate 2 has a layer of silicon nitride 4, a layer of amorphous silicon 6 and a metal layer 8 deposited upon it. A layer of photoresist 10 is then deposited across the substrate. The methods of depositing such layers are standard and well known in the art. The substrate may be of any convenient material, such as glass.

A photo mask 12 is then provided having a UV-transparent mask substrate 14, a patterned layer of silicon-rich silicon nitride half-tone mask material 16 on the substrate and a chromium light blocking layer 18 over part of the silicon nitride half-tone mask material. The photo mask 12 is thus divided into three regions. In light-blocking regions 20 where the chromium light blocking layer 18 is present UV light is substantially all absorbed by the mask. In clear regions 22 where neither the half-tone mask material nor the light blocking chromium layer is present, UV light passes through the mask with little absorption. In half-tone regions 24, only the half-tone mask material and not the chromium light blocking layer are present. In these regions, the transmission of UV light is in the range 20% to 80%.

The layer of silicon-rich silicon nitride 16 has a thickness of 60nm and a band gap of 2.3eV. These parameters may be varied depending on the UV light properties, as will be explained in more detail below.

The photo mask 12 is placed in registration with the substrate and a UV light source 30 having a predetermined wavelength is directed through the photo mask 12 onto the photoresist 10 to pattern the photoresist. After exposure, the photo mask 12 is removed and the photoresist 10 developed to give two different thicknesses of photoresist.

In regions 32 of the photoresist layer 10 that are exposed through the clear regions 22 of the mask, the photoresist 10 is fully removed forming fully removed regions. In regions 30 corresponding and adjacent to the light-blocking regions 20 of the mask, the photoresist remains with a first thickness forming thick regions. In regions 34 of the photoresist layer 10 that are exposed through the half-tone regions 24, the photoresist 10 is processed to have a reduced thickness less than the first thickness forming thin regions 34. In particular, the reduced thickness is preferably 40% to 60% of the first thickness, further preferably approximately 50%. The steps of exposure of the photoresist 10 and development accordingly result in the pattern shown in Figure 2(b).

The reason that it is possible to process photoresist to have multiple thicknesses is that photoresist contains a photo-active additive that is strongly absorbing for UV light and is a dissolution inhibitor for the bulk of the photoresist polymer layer. Unexposed regions of photoresist can be immersed in photoresist developer for long periods without removing any of the photoresist. On exposure to UV light, photons are absorbed on the top surface of the photoresist. Photo chemical reactions then occur that alter the photo-active additive so that it no longer acts as a dissolution inhibitor. It is also bleached so that UV light can pass through exposed layers deeper into the photoresist layer. The combined action of photo bleaching and destroying the dissolution inhibitor means that UV exposure is a top-down process. If the photoresist is only exposed for a short time so that the complete layer has not be effectively exposed, only the upper parts of the photoresist will be removed in the subsequent development step, leaving a thinner but complete layer of photoresist. Only the layers of photoresist in which there is effectively no longer any dissolution inhibitor will dissolve quickly in the photoresist developer solution.

Thus, by exposing the photoresist 10 through the mask 12 for the correct amount of time and then developing the fully removed regions 32 of photoresist under clear regions 20 of the mask are fully removed and the thin regions 34 of photoresist under half-tone regions 24 of the mask receive only half of the light necessary to expose the whole film and hence about half the photoresist thickness will remain in this region after development.

As shown in Figure 2(c), the next step is to etch both the metal 8 and amorphous silicon 6 layers through the fully removed regions 32.

Next, as illustrated in Figure 2(d), the photoresist 10 is partially etched in an oxygen plasma. This removes the thin regions 34 of photoresist, while still leaving a thin layer of photoresist in the thick regions 30. The new photoresist pattern is then used to etch the metal layer 8 but not the amorphous silicon layer 6, and the photoresist is then removed leading to the pattern illustrated in Figure 2(e).

Figure 3 shows a plan view of an etched source-drain metal layer 8 and amorphous silicon layer 6 in a thin film transistor. It will be noted that the amorphous silicon layer 6 extends under the whole of the regions of the metal source and drain metalisation 8. In other words, the top pattern of the metal layer 8 lies wholly within the boundary of the amorphous silicon layer 6.

The most difficult aspect of this process is to reliably achieve multiple levels of photoresist with a controlled thickness. By using the silicon-rich silicon nitride as the half-tone mask layer, in accordance with the present invention, difficulties associated with diffraction pattern half-tone masks can be avoided. The feature size of the mask matches the size of the features to be patterned, and is not reduced as would be required for diffraction grating approaches. This in turn means that lack of uniformity in mask writing caused by small feature sizes is reduced by the larger feature sizes available using the present approach. Further, the approach avoids the sloping photoresist edges that are characteristic of features patterned with diffraction grating masks, and hence avoids the poor uniformity of feature size associated with such sloping photoresist edges.

The use of silicon rich silicon offers the further benefit that the precise properties of the silicon-rich silicon nitride layer 16 may be varied depending in particular on the wavelength of light emitted by the ultraviolet light source 30.

The silicon-rich silicon nitride may be deposited on the mask using plasma deposition, which makes it possible to deposit silicon nitride SiNₓ with a fraction of nitrogen x in the layer varying from 0.001 to 1.4. As the amount of nitrogen increases the optical band gap of the material increases from 1.7eV to 6.0eV. In the invention, the absorption edge of the silicon nitride is controlled to control the amount of light transmitted through the silicon nitride. Typically, UV processing uses the g, h and i emission lines of mercury lights. Therefore, in this case the silicon nitride should have an absorption edge in the region of 400 to 500nm which corresponds to roughly 2.1 to 2.5eV.

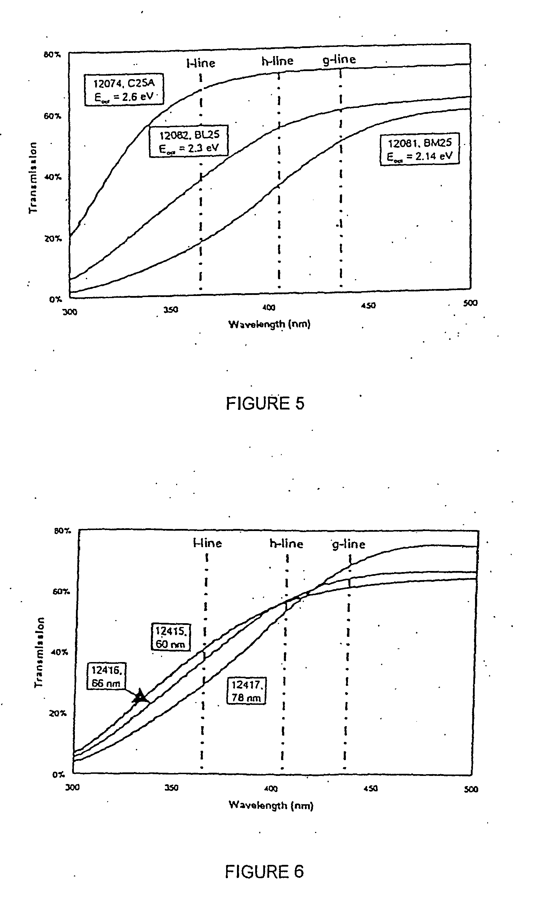

Figure 4 shows the band gap of the deposited silicon rich silicon nitride as a function of the ammonia: silane ratio in the plasma deposition process. It will be seen by varying this ratio, a variety of different band gaps may be obtained.

Figure 5 shows the effect of changing the optical band gap for a 60nm thick layer of silicon nitride. As may be seen, the optical transmission is a strong function of the band gap. Accordingly, by controlling the band gap it is a relatively straight forward problem to accurately control the transmission through the silicon nitride mask layer. Thus, by using silicon nitride obtaining an accurate optical transmission is relatively straightforward. Accordingly, the silicon rich silicon nitride layer 16 may preferably be manufactured to have a band gap in the range 2.15eV to 2.35eV to correspond to the wavelengths of widely used UV light sources 30, in particular the i-line, h-line or g-line of mercury lamps.

The approach of using silicon-rich silicon nitride has the further benefit that the thickness of the silicon nitride layer is not particularly critical. Figure 6 illustrates the optical transmission through different thicknesses of silicon nitride with an optical band gap of 2.3eV. As is clear from the figures, small variations in the thickness of the silicon nitride layer do not lead to wild variations in the transmission. Accordingly, it is possible to reliably obtain a mask layer of substantially uniform transmission across the whole area of the mask. The mask layer thickness may be, for example, in the range 40nm to 100nm.

It will be appreciated that the masks used in the manufacture of active matrix liquid crystal displays are large and so are inherently subject to variation in thickness of mask material across their width. Preferably, the variation in thickness of mask material is no more than 20%, further preferably 10%.

From reading the present disclosure, other variations and modifications will be apparent to persons skilled in the art. Such variations and modifications may involve equivalent and other features which are already known in the design, manufacture and use of masks and which may be used in addition to or instead of features described herein. Although claims have been formulated in this application to particular combinations of features, it should be understood that the scope of disclosure also includes any novel feature or any novel combination of features disclosed herein either explicitly or implicitly or any generalisation thereof, whether or not it mitigates any or all of the same technical problems as does the present invention. The applicants hereby give notice that new claims may be formulated to any such features and/or combinations of such features during the prosecution of the present application or of any further applications derived therefrom.

For example, although the example describes the use of a positive photoresist process, a similar approach may be used with negative photoresist.

Further, although the process has been described for use with an AMLCD structure, it is also of use in the manufacture of other structures, for example MEMS, particularly using a combination of metal, silicon, plastic and dielectric layers in a process involving photolithographic patterning. MEMS can have similar feature sizes to thin film devices.

## Claims

1. A half-tone mask (12) for use in the forming of a multilevel photoresist structure, comprising:
a mask substrate (14);
a half-tone layer (16) of half-tone mask material arranged in a pattern across the mask substrate; and
a light-blocking layer (18) of light blocking material arranged in a pattern across the half-tone layer;
wherein the half-tone mask material (16) is silicon-rich silicon nitride SiNₓ:H with x smaller or equal to 1.

2. A mask according to claim 1 wherein the silicon-rich silicon nitride layer (16) has a value of x in the range 0.2 to 0.6 and an optical band gap of from 2.1eV to 2.5eV.

3. A mask according to claim 1 or 2 wherein the silicon-rich silicon nitride layer (16) has a thickness of from 40nm to 100nm.

4. Use of a mask according to any preceding claim including exposing a layer of photoresist (10) by passing ultra-violet light through the mask (12) onto the layer of photoresist (10) to define fully removed regions (32) in which the photoresist is fully removed, thick regions (30) having a first thickness and thin regions (34) having a thickness less than the first thickness in the regions exposed through the half-tone regions.

5. A method of manufacture of a half-tone mask for use with an ultra-violet light source of predetermined wavelength in the forming of a multilevel photoresist structure, comprising:
providing a mask substrate (14);
depositing a half-tone layer (16), and
depositing an ultra-violet blocking layer (18) on the mask substrate;
wherein the half-tone layer is of silicon rich silicon nitride SiNₓ:H with a nitrogen fraction x smaller or equal to 1 controlled to provide a predetermined band gap for partially absorbing ultra-violet light of the predetermined wavelength.

6. A method of manufacture of a thin film device including:
depositing multiple layers (6, 8) on a substrate (2);
providing a half-tone mask (12) according to any one of Claims 1 to 3;
depositing photoresist (10) on the multiple layers (6, 8) on the substrate (2);
passing ultra-violet light through the mask (12) onto the layer of photoresist (10) to pattern the photoresist (10) to define fully removed regions (32) in which the photoresist is fully removed, thick regions (30) having a first thickness and thin regions (34) having a thickness less than the first thickness in the regions exposed through the half-tone regions;
carrying out a first processing step on the fully removed regions (32);
thinning the photoresist (10) to remove photoresist in the thin regions but not in the thick regions; and
carrying out a second processing step on the thin regions (34).

7. A method according to claim 6 wherein the step of thinning the photoresist (10) is carried out by an oxygen plasma etch.

8. A method according to claim 6 or 7 wherein the multiple layers deposited on the substrate include a silicon nitride layer (4), an amorphous silicon layer (6) deposited on the silicon nitride layer and a metal layer (8) deposited on the amorphous silicon layer;
the first processing step includes etching the metal layer (8) and the amorphous silicon layer (6); and
the second processing step includes etching the metal layer (8).

## Patentansprüche

1. Halbtonmaske (12) zur Verwendung bei der Ausbildung einer Mehrschichtresiststruktur mit
- einem Maskensubstrat (14),
- einer Halbtonschicht (16) aus Halbtonmaskenmaterial, welche in einer Struktur über dem Maskensubstrat angeordnet ist, sowie
- einer Lichtabschirmungsschicht (18) aus einem Licht abschirmenden Material, welche in einer Struktur über der Halbtonschicht angeordnet ist,
wobei das Halbtonmaskenmaterial (16) siliciumreiches Siliciumnitrid SiNₓ:H ist, wobei x kleiner als 1 oder gleich 1 ist.

2. Maske nach Anspruch 1, wobei die siliciumreiche Siliciumnitridschicht (16) einen Wert x im Bereich von 0,2 bis 0,6 und einen optischen Bandabstand von 2,1eV bis 2,5eV aufweist.

3. Maske nach Anspruch 1 oder 2, wobei die siliciumreiche Siliciumnitridschicht (16) eine Dicke von 40nm bis 100nm aufweist.

4. Verwendung einer Maske nach einem der vorangegangenen Ansprüche, wonach eine Schicht (10) aus Photolack belichtet wird, indem Ultraviolettlicht durch die Maske (12) auf die Schicht (10) geleitet wird, um vollständig entfernte Bereiche (32), in denen der Photolack komplett entfernt wird, dicke Bereiche (30) mit einer ersten Dicke sowie dünne Bereiche (34) mit einer Dicke, welche geringer als die erste Dicke in den durch die Halbtonbereiche belichteten Bereichen ist, zu definieren.

5. Verfahren zur Herstellung einer Halbtonmaske zur Verwendung mit einer Ultraviolettlichtquelle einer vorgegebenen Wellenlänge bei der Ausbildung einer Mehrschichtresiststruktur, wonach
- ein Maskensubstrat (14) vorgesehen wird,
- eine Halbtonschicht (16) abgeschieden wird, und
- eine Ultraviolett-Abschirmungsschicht (18) auf dem Maskensubstrat aufgebracht wird,
wobei die Halbtonschicht aus siliciumreichem Siliciumnitrid SiNₓ:H mit einem Stickstoffanteil x, welcher kleiner als 1 oder gleich 1 ist, besteht, wobei dieser so gesteuert wird, dass ein vorgegebener Bandabstand vorgesehen wird, um Ultraviolettlicht der vorgegebenen Wellenlänge teilweise zu absorbieren.

6. Verfahren zur Herstellung eines Dünnschichtbauelements, wonach
- mehrere Schichten (6, 8) auf einem Substrat (2) aufgebracht werden,
- eine Halbtonmaske (12) nach einem der Ansprüche 1 bis 3 vorgesehen wird,
- Photolack (10) auf den mehreren Schichten (6, 8) auf dem Substrat (2) aufgetragen wird,
- zur Strukturierung des Photolacks (10) Ultraviolettlicht durch die Maske (12) auf die Schicht aus Photolack (10) geleitet wird, um vollständig entfernte Bereiche (32), in welchen der Photolack komplett entfernt wird, dicke Bereiche (30) mit einer ersten Dicke sowie dünne Bereiche (34) mit einer Dicke, welche geringer als die erste Dicke in den durch die Halbtonbereiche belichteten Bereichen ist, zu definieren,
- ein erster Verfahrensschritt zur Bearbeitung der vollständig entfernten Bereiche (32) ausgeführt wird,
- der Photolack (10) reduziert wird, um Photolack in den dünnen Bereichen, nicht jedoch in den dicken Bereichen zu entfernen, und
- ein zweiter Verfahrensschritt zur Bearbeitung der dünnen Bereiche (34) ausgeführt wird.

7. Verfahren nach Anspruch 6, wobei der Schritt zur Reduzierung des Photolacks (10) durch eine Sauerstoffplasmaätzung ausgeführt wird.

8. Verfahren nach Anspruch 6 oder 7, wobei die auf dem Substrat aufgebrachten, mehreren Schichten eine Siliciumnitridschicht (4), eine auf der Siliciumnitridschicht aufgebrachte Schicht (6) aus amorphem Silicium sowie eine auf der Schicht aus amorphem Silicium aufgebrachte Metallschicht (8) umfassen,
- wobei der erste Verfahrensschritt die Ätzung der Metallschicht (8) und der Schicht (6) aus amorphem Silicium umfasst, und
- wobei der zweite Verfahrensschritt die Ätzung der Metallschicht (8) umfasst.

## Revendications

1. Masque tramé (12) à utiliser pour la formation d'une structure de photorésist multiniveau, comprenant :
un substrat de masque (14);
une couche tramée (16) de matériau de masque tramé disposé suivant un motif dans l'ensemble du substrat de masque, et
une couche bloquant la lumière (18) de matériau bloquant la lumière disposé suivant un motif dans l'ensemble de la couche tramée;
le matériau de masque tramé (16) étant un nitrure de silicium à forte teneur en silicium SiNHₓ :H avec x inférieur ou égal à 1.

2. Masque suivant la revendication 1, dans lequel la couche de nitrure de silicium à forte teneur en silicium (16) présente une valeur de x comprise dans l'intervalle de 0,2 à 0,6 et une bande interdite optique comprise entre 2,1 eV et 2,5 eV.

3. Masque suivant la revendication 1 ou 2, dans lequel la couche de nitrure de silicium à forte teneur en silicium (16) présente une épaisseur comprise entre 40 nm et 100 nm.

4. Utilisation d'un masque suivant l'une quelconque des revendications précédentes, comprenant l'exposition d'une couche de photorésist (10) en faisant passer une lumière ultraviolette à travers le masque (12) jusque sur la couche de photorésist (10), de manière à définir des régions d'élimination complète (32), dans lesquelles le photorésist est entièrement éliminé, des régions épaisses (30) présentant une première épaisseur, et des régions minces (34) présentant une épaisseur inférieure à la première épaisseur dans les régions exposées à travers les régions tramées.

5. Procédé de fabrication d'un masque tramé à utiliser avec une source de lumière ultraviolette de longueur d'onde prédéterminée lors de la formation d'une structure de photorésist multiniveau, comprenant:
la fourniture d'un substrat de masque (14);
le dépôt d'une couche tramée (16), et
le dépôt d'une couche bloquant les ultraviolets (18) sur le substrat de masque;
la couche tramée étant en nitrure de silicium à forte teneur en silicium SiNₓ :H, avec une fraction d'azote x inférieure ou égale à 1, contrôlée afin de fournir une bande interdite prédéterminée destinée à absorber en partie la lumière ultraviolette de la longueur d'onde prédéterminée.

6. Procédé de fabrication d'un dispositif à couches minces, comprenant :
le dépôt de couches multiples (6, 8) sur un substrat (2);
la fourniture d'un masque tramé (12) suivant l'une quelconque des revendications 1 à 3;
le dépôt d'un photorésist (10) sur des couches multiples (6, 8) sur le substrat (2);
le passage d'une lumière ultraviolette à travers le masque (12) jusque sur la couche de photorésist (10) de manière à créer un motif sur le photorésist (10) et à définir des régions d'élimination complète (32), dans lesquelles le photorésist est entièrement éliminé, des régions épaisses (30) présentant une première épaisseur, et des régions minces (34) présentant une épaisseur inférieure à la première épaisseur dans les régions exposées à travers les régions tramées,
l'exécution d'une première étape de traitement sur les régions d'élimination complète (32);
l'amincissement du photorésist (10) afin d'éliminer le photorésist dans les régions minces, et pas dans les régions épaisses, et
l'exécution d'une seconde étape de traitement sur les régions minces (34).

7. Procédé suivant la revendication 6, dans lequel l'étape d'amincissement du photorésist (10) est exécutée par une attaque chimique au plasma oxygène.

8. Procédé suivant la revendication 6 ou 7, dans lequel les couches multiples déposées sur le substrat comprennent une couche de nitrure de silicium (4), une couche de silicium amorphe (6) déposée sur la couche de nitrure de silicium, et une couche métallique (8) déposée sur la couche de silicium amorphe;
la première étape de traitement comprend une attaque chimique de la couche métallique (8) et de la couche de silicium amorphe (6), et
la seconde étape de traitement comprend l'attaque chimique de la couche métallique (8).
